# EUROPEAN PATENT APPLICATION

(11) **EP 4 826 743 A1**
(43) Date of publication of application: **21.10.2026**
(21) Application number: 24910035.5
(22) Date of filing: 18.09.2024
(51) Int. Cl.: H01B 12/00

(54) **MEMORY ARRAY AND MANUFACTURING METHOD THEREFOR, AND MEMORY AND ELECTRONIC DEVICE**

(30) Priority: 26.12.2023 CN 202311816759
(71) Applicant: Huawei Technologies Co., Ltd., Shenzhen, Guangdong 518129 (CN)
(72) Inventor: WANG, Chao, Shenzhen, Guangdong 518129 (CN); LV, Hangbing, Shenzhen, Guangdong 518129 (CN); XU, Yannan, Shenzhen, Guangdong 518129 (CN); GU, Junxing, Shenzhen, Guangdong 518129 (CN); XU, Shengqiang, Shenzhen, Guangdong 518129 (CN); DU, Kai, Shenzhen, Guangdong 518129 (CN); SU, Diqing, Shenzhen, Guangdong 518129 (CN)
(74) Representative: Huawei European IPR
(86) International application number: PCT/CN2024/119510
(87) International publication number: WO 2025/139090

(57) **Abstract**

This application relates to the field of electronic technologies, and provides a memory array, a preparation method therefor, a memory, and an electronic device, to resolve a problem of low integration density of a capacitor structure in the memory. The memory array includes a substrate and capacitor units disposed on the substrate. The capacitor unit includes a first electrode, a second electrode, and a third electrode. The first electrode, the second electrode, and the third electrode all extend in a thickness direction of the substrate. The first electrode is disposed around the second electrode, and the second electrode is disposed around the third electrode. The capacitor unit further includes a first dielectric layer and a second dielectric layer. The first dielectric layer is disposed between the first electrode and the second electrode, and the second dielectric layer is disposed between the second electrode and the third electrode. The memory array is configured to increase integration density of the capacitor structure.

## Description

This application claims priority to Chinese Patent Application No. 202311816759.2, filed with the China National Intellectual Property Administration on December 26, 2023 and entitled "MEMORY ARRAY, PREPARATION METHOD THEREFOR, MEMORY, AND ELECTRONIC DEVICE", which is incorporated herein by reference in its entirety.

### TECHNICAL FIELD

This application relates to the field of electronic technologies, and in particular, to a memory array, a preparation method therefor, a memory, and an electronic device.

### BACKGROUND

With booming development of artificial intelligence, big data, and large models, people are paying more attention to data generated in various activities. Desired information can be obtained by analyzing the data. For example, personal profiling of specific users can be depicted by analyzing search data, browsing data, and purchase data of the users on shopping websites, to implement precise advertisement delivery, thereby improving user experience and increasing the transaction conversion rate of advertisements. For another example, ride information of subways, buses, and shared bicycles in a city can be obtained, to optimize the route planning of subways and buses, the departure interval of the same route, the distribution of shared bicycles, and the like. Obviously, the data needs to be stored after being obtained, or the data needs to be stored in an internal memory or a cache when being analyzed. An apparatus for storing the data is a memory.

The memory may be classified into a volatile (volatile) memory and a non-volatile (non-volatile) memory based on volatility. The volatile memory is usually used as an internal memory or a cache, and the non-volatile memory is usually used as an external memory. The volatile memory is a memory in which stored information disappears after a current or voltage is interrupted. However, in the non-volatile memory, stored information does not disappear after a power failure.

In some technologies, a memory cell of the memory usually uses a capacitor structure, and the data is stored by charging and discharging the capacitor structure. To ensure effective data storage of the memory, a requirement is imposed on the capacitance of the capacitor structure. In a current technology, to meet the requirement on the capacitance of the capacitor structure, the capacitor structure needs to have a large size, making it difficult to achieve further size reduction. Therefore, how to increase integration density of the capacitor structure in the memory is an urgent problem to be resolved.

### SUMMARY

Embodiments of this application provide a memory array, a preparation method therefor, a memory, and an electronic device, to resolve a problem of low integration density of a capacitor structure in the memory.

To achieve the foregoing objectives, the following technical solutions are used in embodiments of this application.

According to a first aspect, an embodiment of this application provides a memory array, including a substrate and capacitor units disposed on the substrate. The capacitor unit includes a first electrode, a second electrode, and a third electrode. The first electrode, the second electrode, and the third electrode all extend in a thickness direction of the substrate, the first electrode is disposed around the second electrode, and the second electrode is disposed around the third electrode. The capacitor unit further includes a first dielectric layer and a second dielectric layer, the first dielectric layer is disposed between the first electrode and the second electrode, and the second dielectric layer is disposed between the second electrode and the third electrode.

The capacitor unit in the memory array includes the first electrode, the second electrode, and the third electrode. The first dielectric layer is disposed between the first electrode and the second electrode, and the second dielectric layer is disposed between the second electrode and the third electrode. Therefore, the first electrode, the second electrode, and the first dielectric layer form a capacitor, and the second electrode, the third electrode, and the second dielectric layer form another capacitor. In other words, the capacitor unit forms two capacitors via three electrodes, and the two capacitors share the second electrode. In this way, forming two capacitors can reduce one electrode, thereby reducing a volume of the capacitor. In addition, because the first electrode, the second electrode, and the third electrode all extend in the thickness direction of the substrate, the formed capacitor unit also extends in the thickness direction. Therefore, an area occupied by the capacitor unit on a surface of the substrate can be reduced, and a process window can be increased. Finally, the first electrode is disposed around the second electrode, the second electrode is disposed around the third electrode, and the capacitor formed by the second electrode, the third electrode, and the second dielectric layer is embedded in the capacitor formed by the first electrode, the second electrode, and the first dielectric layer. In addition, to meet a requirement of a read window, a capacitor in a memory cell needs to have a specific capacitance value, which may be implemented by making an electrode of the capacitor greater than a specific area. The first electrode is disposed around the second electrode, and the second electrode is disposed around the third electrode, so that an area of the electrode can be increased, that is, the capacitance value of the capacitor can be increased. Therefore, when capacitance values of capacitors are equal, a volume of the capacitor can further be reduced. Reducing the volume of the capacitor can increase integration density of the capacitor and increase storage density of the memory cell.

In a possible implementation of the first aspect, at least a part of the second electrode is cylindrical, and at least a part of the first electrode is cylindrical. In this way, the second electrode with the cylindrical part may be formed by depositing a conductive material on an inner surface of a deep hole, and the first electrode with the cylindrical part may also be formed by depositing a conductive material after the second dielectric layer is formed outside the second electrode. In this way, the second electrode and the first electrode may be formed by using a mature semiconductor process.

In a possible implementation of the first aspect, the first dielectric layer is connected to the second dielectric layer on a side that is away from the substrate. In this way, after the second electrode is formed, a dielectric material may be deposited on a surface of the second electrode, and the first dielectric layer and the second dielectric layer are formed at the same time. This can reduce process steps.

In a possible implementation of the first aspect, the memory array includes the plurality of capacitor units arranged in an array, and third electrodes or first electrodes of any two adjacent capacitor units in one row of capacitor units are connected to each other. In this way, capacitors included in all capacitor units in the row may be connected in series, to form a memory.

In a possible implementation of the first aspect, the memory array further includes a first connection structure, disposed on a side that is of the two adjacent capacitor units and that is away from the substrate, where the third electrodes of the two adjacent capacitor units are connected to each other via the first connection structure. In this way, the first connection structure is disposed on a side that is away from the capacitor unit, and the first connection structure can be formed after the capacitor unit is formed, thereby facilitating disposition of the first connection structure in the memory array.

In a possible implementation of the first aspect, the memory array further includes: a plurality of transistors, disposed between the substrate and the plurality of capacitor units;

and contact structures, where one end of the contact structure is connected to the first connection structure, and the other end of the contact structure is connected to at least one transistor. In this way, the first connection structure connected to the third electrodes of the two adjacent capacitor units may be connected to the transistor via the contact structure, so that the transistor controls storage states of capacitors in which the third electrodes are located.

In a possible implementation of the first aspect, the third electrodes of the two adjacent capacitor units, the first connection structure, and the contact structure are made of a same material and are disposed integrally. In this way, good contact can be formed on an interface of connection between the third electrodes, the first connection structure, and the contact structure, and a problem that mutual diffusion occurs due to different materials and affects resistance at a connection point is avoided.

In a possible implementation of the first aspect, the memory array further includes a second connection structure, disposed between the two adjacent capacitor units and disposed close to the substrate, where the first electrodes of the two adjacent capacitor units are connected to each other via the second connection structure. In this way, the first electrodes of the two adjacent capacitor units are connected via the second connection structure. The second connection structure is disposed close to the substrate, which helps form the second connection structure on the surface of the substrate.

In a possible implementation of the first aspect, the memory array further includes a plurality of transistors, disposed between the substrate and the plurality of capacitor units, where the second connection structure is in contact with at least one transistor. In this way, the second connection structure may be directly disposed on the transistor formed on the substrate, and may be in contact with the transistor.

In a possible implementation of the first aspect, the first electrodes of the two adjacent capacitor units and the second connection structure are made of a same material and are disposed integrally. In this way, the second connection structure can be prepared while the first electrode is formed through deposition.

In a possible implementation of the first aspect, the memory array further includes first connection structures and second connection structures. In one row of capacitor units, the first connection structures and the second connection structures are alternately disposed. In this way, a first electrode of one capacitor unit in one row may be connected to a first electrode of one capacitor before the capacitor unit via the second connection structure, and a third electrode of the capacitor unit may be connected to a third electrode of one capacitor after the capacitor unit via the first connection structure, to implement series connection between the capacitors in the capacitor units in the row.

In a possible implementation of the first aspect, the plurality of transistors of the memory array include a first transistor and a second transistor, a first electrode of the first transistor is connected to the first electrode, both a second electrode of the first transistor and a first electrode of the second transistor are connected to the second electrode, and a second electrode of the second transistor is connected to the third electrode. In this way, each capacitor in one capacitor unit is connected in parallel to one transistor.

In a possible implementation of the first aspect, the second electrode of the first transistor and the first electrode of the second transistor are a same electrode. The second electrode includes a cylindrical first part and a second part located at an end that is of the first part and that is close to the substrate, an edge of the second part is connected to the end that is of the first part and that is close to the substrate, and the second part is in contact with the same electrode. In this way, the first part and the second part of the second electrode can be formed at the same time through deposition on an inner surface of a deep hole formed on a same gate. This reduces process steps.

In a possible implementation of the first aspect, the plurality of transistors in the memory array are arranged in an array, and one row of transistors are disposed in series, and are correspondingly connected to one row of capacitor units. The memory array further includes a plurality of word lines embedded in the substrate, and one word line is connected to gates of one column of transistors. Because the plurality of word lines in the substrate are embedded in the substrate, the transistor may be formed only on one side of the surface of the substrate, and the capacitor unit may be formed on the other side of the surface of the substrate. This facilitates corresponding connection between one row of transistors and one row of capacitor units.

In a possible implementation of the first aspect, the memory array further includes a first bit line and a second bit line. A plurality of transistors in the memory array include a first transistor and a second transistor, a first electrode of the first transistor is connected to the first bit line, a second electrode of the first transistor is connected to the first electrode, a first electrode of the second transistor is connected to the third electrode, a second electrode of the second transistor is connected to the second bit line, and the second electrode is connected to a power signal end. In this way, one transistor is connected to one electrode of one capacitor in the capacitor unit, and one electrode shared by two capacitors in the capacitor unit, namely, a second electrode, is connected to a power signal end, so that the one transistor controls a storage state of the one capacitor.

In a possible implementation of the first aspect, both the first dielectric layer and the second dielectric layer are made of a ferroelectric material. In this way, the formed capacitor is a ferroelectric capacitor, which helps increase a read/write speed of the memory array and improve durability of the memory array.

According to a second aspect, this application provides a preparation method for a memory array, including: forming second electrodes on a substrate, where the second electrodes extend in a thickness direction of the substrate; forming a first dielectric layer on a side of the second electrode, and forming a second dielectric layer on another side of the second electrode; and forming a first electrode on a side that is of the first dielectric layer and that is away from the second electrode, and forming a third electrode on a side that is of the second dielectric layer and that is away from the second electrode, where the first electrode and the second electrode extend in the thickness direction of the substrate, the second electrode surrounds the first electrode, and the third electrode surrounds the second electrode.

In a possible implementation of the second aspect, the first dielectric layer and the second dielectric layer are formed at the same time. In this way, after the second electrode is formed, a dielectric material may be deposited on a surface of the second electrode, and the first dielectric layer and the second dielectric layer are formed. This reduces process steps.

According to a third aspect, this application provides a memory, including a peripheral circuit and a memory array in any implementation of the first aspect, where the peripheral circuit is electrically connected to the memory array. Because the memory uses the memory array in the first aspect, the memory also has high storage density.

According to a fourth aspect, this application provides an electronic device, including a printed circuit board and the memory in the third aspect, where the memory is disposed on the printed circuit board. Because the electronic device uses the memory in the third aspect, the electronic device also has good storage performance.

### BRIEF DESCRIPTION OF DRAWINGS

FIG. 1 is a diagram of an electronic device according to an embodiment of this application;
FIG. 2 is a diagram of a structure of a memory according to an embodiment of this application;
FIG. 3 is a top view of a structure of a memory array according to an embodiment of this application;
FIG. 4 is a diagram of a cross-sectional structure of the memory array in FIG. 3 in an A-A direction;
FIG. 5 is a diagram of a structure of a capacitor unit in a memory array according to an embodiment of this application;
FIG. 6 is a circuit schematic of the memory array in FIG. 3;
FIG. 7 is a diagram of a front cross-sectional structure of another memory array according to an embodiment of this application;
FIG. 8 is a top view of a structure of the memory array in FIG. 7;
FIG. 9 is a flowchart of preparing a memory array according to an embodiment of this application;
FIG. 10 is a diagram of a three-dimensional structure of a substrate provided during preparation of a memory array according to an embodiment of this application;
FIG. 11 is a diagram of a cross-sectional structure in a B-B direction in FIG. 10;
FIG. 12 is a diagram of a structure after second electrodes are formed during preparation of a memory array according to an embodiment of this application;
FIG. 13 is a diagram of a cross-sectional structure in a C-C direction in FIG. 12;
FIG. 14 is a diagram of a structure after a sacrificial layer is removed during preparation of a memory array according to an embodiment of this application;
FIG. 15 is a diagram of a cross-sectional structure in an E-E direction in FIG. 14;
FIG. 16 is a diagram of a structure after a first dielectric layer and a second dielectric layer are formed during preparation of a memory array according to an embodiment of this application;
FIG. 17 is a diagram of a cross-sectional structure in an F-F direction in FIG. 16;
FIG. 18 is a diagram of a structure after a part of dielectric layer is removed during preparation of a memory array according to an embodiment of this application;
FIG. 19 is a diagram of a cross-sectional structure in a G-G direction in FIG. 18;
FIG. 20 is a diagram of a structure after a redundant conductive material is removed and a second connection structure is formed during preparation of a memory array according to an embodiment of this application;
FIG. 21 is a diagram of a cross-sectional structure in an H-H direction in FIG. 20;
FIG. 22 is a diagram of a structure after a redundant conductive material is removed and a first connection structure is formed during preparation of a memory array according to an embodiment of this application; and
FIG. 23 is a diagram of a cross-sectional structure in an I-I direction in FIG. 22.

### DESCRIPTION OF EMBODIMENTS

Unless otherwise defined, technical terms or scientific terms used in this application should have general meanings understood by a person skilled in the art. In the specification and claims of this application, the terms "first", "second", "third", and the like are not intended to indicate any order, quantity, or significance, but are merely intended to distinguish between different components. Therefore, a feature limited by "first", "second", or "third" may explicitly or implicitly include one or more features. In descriptions of embodiments of this application, unless otherwise specified, "a plurality of" means two or more than two.

Position terms such as "left", "right", "up", and "down" are defined with respect to positions of components in accompanying drawings. It should be understood that these directional terms are relative concepts used for relative description and clarification, and can correspondingly change based on a change of a position in which a chip or a semiconductor package structure is placed.

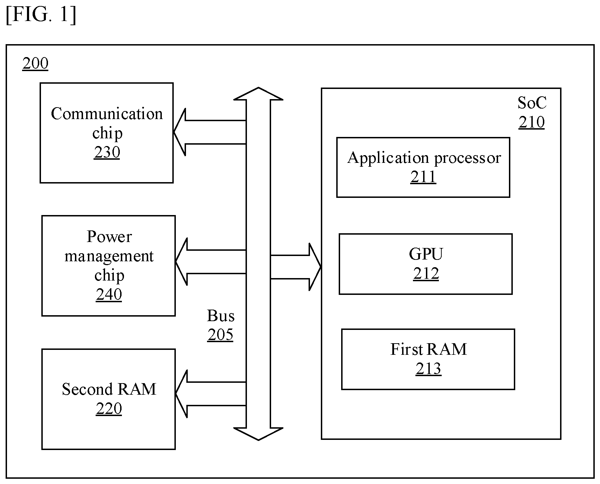

FIG. 1 is a diagram of a structure of an electronic device 200 according to an embodiment of this application. The electronic device 200 may be a terminal device, for example, a mobile phone, a tablet computer, or a smart band, or may be a personal computer (personal computer, PC), a server, a workstation, or the like. The electronic device 200 includes a bus 205 and a system on chip (System on Chip, SoC) 210 connected to the bus 205.

The system on chip 210 may be configured to process data, for example, process data of an application, process image data, and cache temporary data. In an implementation, the system on chip 210 may include one or more processors, for example, an application processor (application processor, AP) 211 configured to process an application, and a graphics processing unit (Graphics Processing Unit, GPU) 212 configured to process image data. The system on chip 210 may further include a first random access memory (Random Access Memory, RAM) 213 configured to cache high-speed data. The first random access memory 213 may be electrically connected to the processor of the system on chip 210, and the first random access memory 213 may be a static random access memory (Static Random Access Memory, SRAM), an embedded flash (embedded flash, eflash), or the like.

The application processor 211, the graphics processing unit 212, and the first random access memory 213 may be integrated into one die (die), or may be separately disposed in a plurality of dies.

The electronic device 200 may further include a second random access memory 220 electrically connected to the system on chip 210 via the bus 205. The second random access memory 220 may be a dynamic random access memory (Dynamic Random Access Memory, DRAM). The second random access memory 220 may be configured to store volatile data, for example, temporary data generated by the system on chip 210. A storage capacity of the second random access memory 220 is usually greater than that of the first random access memory 213, but a read speed of the second random access memory 220 is usually slower than that of the first random access memory 213.

In addition, the electronic device 200 may further include a communication chip 230 and a power management chip 240 that are connected to the system on chip 210 via the bus 205. The communication chip 230 may be configured to process a protocol stack, or perform processing such as amplification and filtering on an analog radio frequency signal, or implement the foregoing functions at the same time. The power management chip 240 may be configured to supply power to another chip. In an implementation, the system on chip 210 and the second random access memory 220 may be packaged in a package structure through, for example, 2.5D (dimension) or 3D packaging, to obtain a high inter-chip data transmission rate.

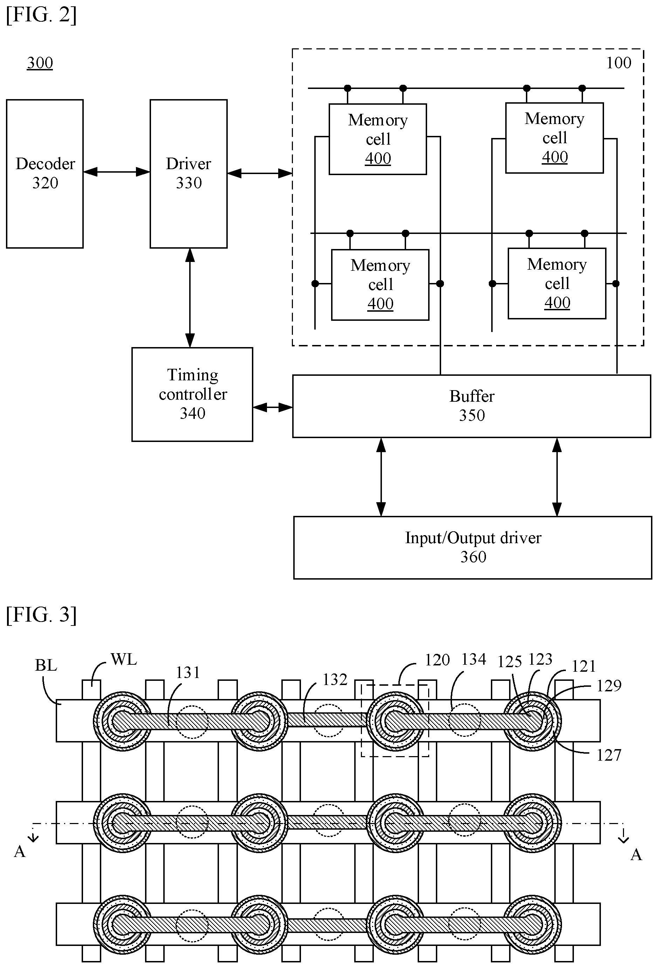

FIG. 2 is a diagram of a structure of a memory 300 according to an embodiment of this application. In an implementation, the memory 300 may be the first random access memory 213 shown in FIG. 1, or may be the second random access memory 220. An application scenario of the memory 300 is not limited in this application.

The memory 300 includes a memory array 100. The memory 300 further includes a controller, and the controller may include one or more peripheral circuits in a decoder 320, a driver 330, a timing controller 340, a buffer 350, or an input/output driver 360.

In an implementation, the memory array 100 includes a plurality of memory cells 400 arranged in an array. The memory cell 400 may include a capacitor, for example, may store 1-bit (bit) or multi-bit data by charging and discharging the capacitor. The memory array 100 may further include signal lines such as a word line (word line, WL) and a bit line (bit line, BL). Each memory cell 400 is electrically connected to a corresponding signal line. One or more of the signal lines may be configured to: receive a control level output by the controller, and select a to-be-read/written memory cell 400 in the memory array, to change a charging/discharging state of the capacitor in the memory cell 400, so as to implement a data read/write operation.

The decoder 320 is configured to decode an address of the memory cell 400. The decoder 320 is configured to perform decoding based on a received address, to determine a to-be-accessed memory cell 400. The driver 330 is configured to control a level of the signal line based on a decoding result generated by the decoder 320, to implement access to the specified memory cell 400. The buffer 350 is configured to buffer read data, for example, buffer the read data in an FIFO (first-in first-out, first-in first-out) manner. The timing controller 340 is configured to: control timing of the buffer 350, and control the driver 330 to drive the signal line in the memory array 100. The input/output driver 360 is configured to drive a transmission signal, for example, drive a received data signal and drive a to-be-sent data signal, so that the data signals can be transmitted over a long distance. The memory array 100, the decoder 320, the driver 330, the timing controller 340, the buffer 350, and the input/output driver 360 may be integrated into one chip, or may be integrated into a plurality of chips.

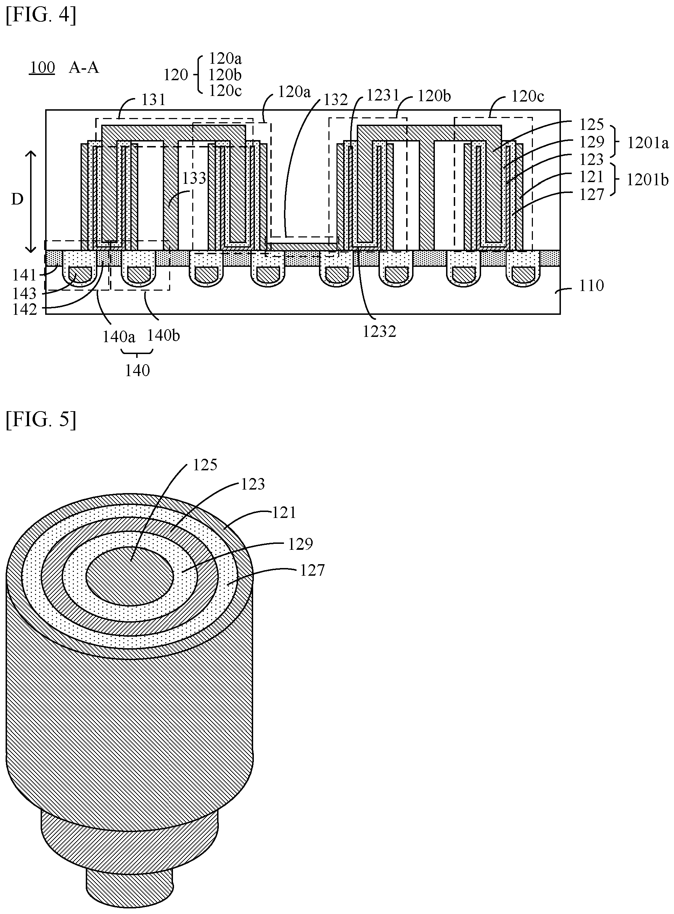

To increase storage density of the memory 300, this application provides a memory array 100. FIG. 3 is a top view of a structure of the memory array 100. FIG. 4 is a diagram of a cross-sectional structure of the memory array 100 in FIG. 3 in an A-A direction. The memory array 100 includes a substrate 110 and capacitor units 120 disposed on the substrate 110.

The substrate 110 may be made of silicon or another semiconductor material, and may include (for example) a doped semiconductor material and/or an undoped semiconductor material. The substrate 110 may include a semiconductor material of another element like germanium (Ge). In some implementations, the substrate 110 may be made of a compound semiconductor like silicon carbide (SiC), gallium arsenide (GaAs), indium arsenide (InAs), or indium phosphide (InP). In some implementations, the substrate 110 may be made of an alloy semiconductor like silicon germanium (SiGe), silicon germanium carbide (SiGeC), gallium arsenide phosphide (GaAsP), or gallium indium phosphide (GaInP). In some implementations, the substrate 110 includes an epitaxial layer. For example, the substrate 110 has an epitaxial layer located on a semiconductor body. In some implementations, the substrate 110 may alternatively be a silicon-on-insulator (SOI) or germanium-on-insulator (GOI) substrate.

The capacitor units 120 are disposed on the substrate 110. FIG. 5 is a diagram of a structure of the capacitor unit 120. With reference to FIG. 4 and FIG. 5, the capacitor unit 120 includes a first electrode 121, a second electrode 123, and a third electrode 125. The first electrode 121, the second electrode 123, and the third electrode 125 all extend in a thickness direction D of the substrate 110. For example, the first electrode 121, the second electrode 123, and the third electrode 125 may be disposed perpendicular to a surface of the substrate 110. The first electrode 121 is disposed around the second electrode 123, and the second electrode 123 is disposed around the third electrode 125. In other words, the first electrode 121 is at least partially sleeved on a periphery of the second electrode 123, and the second electrode 123 is at least partially sleeved on a periphery of the third electrode 125. The first electrode 121, the second electrode 123, and the third electrode 125 may include a conductive material. The conductive material may be one or more of doped polycrystalline silicon, metal, or a metal compound material, and various other appropriate electrode materials, for example, titanium nitride (TiN), tungsten (W), and molybdenum (Mo).

The capacitor unit 120 further includes a first dielectric layer 127 and a second dielectric layer 129. The first dielectric layer 127 is disposed between the first electrode 121 and the second electrode 123, and separates the first electrode 121 from the second electrode 123. The second dielectric layer 129 is disposed between the second electrode 123 and the third electrode 125, and separates the second electrode 123 from the third electrode 125. In this way, the first electrode 121, the second electrode 123, and the first dielectric layer 127 form a capacitor 1201b, and the second electrode 123, the third electrode 125, and the second dielectric layer 129 form another capacitor 1201a. In other words, one capacitor unit 120 includes two capacitors, and the two capacitors share one electrode, that is, share the second electrode 123. In this way, forming two capacitors can reduce one electrode, thereby reducing a volume of the capacitor, and helping increase integration density of the memory array 100. In addition, the capacitor of the capacitor unit 120 needs to have a specific capacitance value. The capacitance value can be increased by making an electrode of the capacitor greater than a specific area. The first electrode 121 surrounds the second electrode 123, and the second electrode 123 surrounds the third electrode 125, so that an area of the electrode can be increased. In this way, the capacitance value of the capacitor can be increased to meet a requirement of a read window.

In some implementations, at least a part of the first electrode 121 may be cylindrical, and at least a part of the second electrode 123 may also be cylindrical. The cylindrical part may have a thin wall, and a cross section perpendicular to the thin wall is a hollow closed shape. Space surrounded by the thin wall communicates with the outside at two extension ends of the thin wall. For example, cylindrical may be tubular, and a cross section of the cylindrical part may be a circular ring. In this way, the second electrode 123 may be inserted into the first electrode 121, that is, the first electrode 121 is disposed around the second electrode 123. The third electrode 125 may be at least partially cylindrical or columnar. In this case, that the first electrode 121 and the second electrode 123 extend in the thickness direction D of the substrate 110 may be that the thin wall extends in the thickness direction D of the substrate 110. Thicknesses of the first electrode 121 and the second electrode 123 may be the same or may be different. The thicknesses of the first electrode 121 and the second electrode 123 may range from 5 nm to 15 nm, for example, may be 5 nm, 8 nm, or 15 nm.

In some implementations, the first dielectric layer 127 and the second dielectric layer 129 may be made of a dielectric material. The dielectric material may be ceramic, for example, aluminum oxide (Al₂O₃) or barium titanate (BaTiO₃), or may be an organic polymer, for example, polyacrylate (PPS) or polyimide (PI), or may be another appropriate dielectric material.

In some possible implementations, the first dielectric layer 127 and the second dielectric layer 129 may be made of a ferroelectric material, for example, one or more of lead zirconate titanate (PZT), strontium bismuth titanate (SBT), a hafnium oxide-based material, a perovskite material (for example, calcium titanate), and lanthanum bismuth titanate, or may be made of another ferroelectric material. In some possible implementations, the ferroelectric material may include a hafnium oxide-based material and/or a zirconia-based material. In addition, the hafnium oxide-based material or the zirconia-based material may be doped with at least one of the following: silicon (Si), aluminum (Al), germanium (Ge), magnesium (Mg), calcium (Ca), strontium (Sr), niobium (Nb), yttrium (Y), barium (Ba), and titanium (Ti). In this case, a memory formed by the ferroelectric material as a dielectric layer of a capacitor unit may be referred to as a ferroelectric memory, which has advantages such as a high speed, good durability, and non-volatility.

In some implementations, thicknesses of the first dielectric layer 127 and the second dielectric layer 129 may be the same or may be different. For example, the thickness of the first dielectric layer 127 is less than the thickness of the second dielectric layer 129. In this way, capacitance values of the two capacitors of the capacitor unit 120 may be as equal as possible by adjusting the thicknesses of the first dielectric layer 127 and the second dielectric layer 129. The thickness of the first dielectric layer 127 or the second dielectric layer 129 may range from 5 nm to 15 nm, for example, may be 5 nm, 8 nm, or 15 nm.

In some implementations, the first dielectric layer 127 and the second dielectric layer 129 may be formed on two sides of the second electrode 123 by using a deposition process. It is easily understood that, to separate adjacent electrodes, the first dielectric layer 127 and the second dielectric layer 129 may also extend in the thickness direction D of the substrate 110. In addition, the first dielectric layer 127 may be connected to the second dielectric layer 129 on a side that is away from the substrate 110, so that the first dielectric layer 127 and the second dielectric layer 129 may be disposed integrally. Therefore, the first dielectric layer 127 and the second dielectric layer 129 may also be formed at the same time by using a same process. The first dielectric layer 127 and the second dielectric layer 129 may be formed by using an appropriate process like a sputtering process or an ALD process.

In some implementations, the memory array 100 may use a 1T1C (1 transistor 1 capacitor) storage architecture. It is easily understood that although this application is described by using only the 1T1C storage architecture as an example, the inventive concept of this application may also be applied to a 1TnC storage architecture or an nTmC storage architecture.

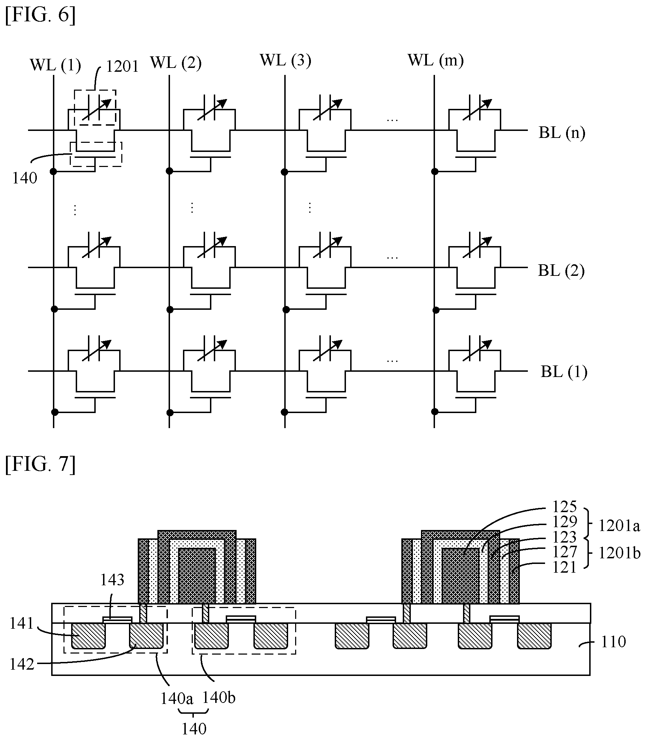

FIG. 6 is a circuit schematic of the memory array 100 in FIG. 3 and FIG. 4. The memory array 100 may include a plurality of word lines WLs disposed in a first direction, for example, a word line WL (1) and a word line WL (2), and a plurality of bit lines BLs disposed in a second direction, for example, a bit line BL (1) and a bit line BL (2), where the first direction intersects the second direction. The bit line BL may include a plurality of capacitors 1201 and a plurality of transistors 140. The plurality of capacitors 1201 are disposed in series, and each capacitor 1201 is connected in parallel to one transistor 140. In other words, the bit line BL may be formed after the plurality of capacitors 1201 are disposed in series, where each capacitor 1201 is connected in parallel to one transistor 140. That a capacitor 1201 is connected in parallel to a transistor 140 means that a first electrode and a second electrode of the transistor 140 are respectively connected to two electrodes of the capacitor 1201. Because the plurality of capacitors 1201 are disposed in series, the plurality of transistors 140 are also disposed in series.

In addition, a gate of each transistor 140 is connected to a word line WL. A same word line WL may be connected to gates of a plurality of transistors 140, and the plurality of transistors 140 are located in different bit lines BL.

Therefore, in an initial state in which data is written into or erased from a capacitor in the memory array 100, a bit line BL corresponding to the capacitor is set to a high level, a plurality of transistors 140 included in the bit line BL are disposed in series, and all the plurality of transistors 140 are conducted. In other words, word lines WL respectively connected to gates of the plurality of transistors 140 are set to a high level. In this way, when the data stored in the capacitor is written or erased, a transistor 140 corresponding to the capacitor may be cut off. In other words, the word line corresponding to the transistor 140 is set to a low level. There is a large voltage drop between two ends of the capacitor, to implement data writing or erasing. However, when a storage state of the capacitor is read, the storage state of the selected capacitor may be determined by controlling voltages of the word line WL and the bit line BL and integrating a read current between the word line WL and the bit line BL.

Based on the foregoing circuit structure, still as shown in FIG. 3 and FIG. 4, the memory array 100 may include the plurality of capacitor units 120 described above. The plurality of capacitor units 120 may be arranged in an array. In other words, the plurality of capacitor units 120 may be arranged in a plurality of rows and a plurality of columns. The row may extend in a horizontal direction in FIG. 3, and the column may extend in a vertical direction in FIG. 3. Quantities of capacitor units 120 in any two rows or columns may be the same or different. It is easily understood that the row and column herein do not strictly limit an arrangement manner of the capacitor units 120, and are merely used to distinguish arrangement of the capacitor units 120 in two different directions. The row and column respectively represent different arrangement directions of the capacitor units 120. The row and column do not require capacitor units 120 in each row or column to be completely aligned.

A plurality of capacitor units 120 in each row may be disposed in series. For example, the plurality of capacitor units 120 include a first capacitor unit 120a, a second capacitor unit 120b, and a third capacitor unit 120c, and the first capacitor unit 120a, the second capacitor unit 120b, and the third capacitor unit 120c are disposed in series. Because a capacitor 1201a and a capacitor 1201b that are included in each capacitor unit 120 share the second electrode 123, the capacitor 1201a and the capacitor 1201b are disposed in series.

To enable the plurality of capacitor units 120 in each row to be disposed in series, a first electrode 121 of one capacitor unit 120 in the row may be connected to a first electrode 121 of an adjacent capacitor unit 120, and a third electrode 125 may be connected to a third electrode 125 of another adjacent capacitor unit 120. In other words, first electrodes 121 or third electrodes 125 of two adjacent capacitor units 120 in the row are connected to each other. For example, a first electrode 121 of the first capacitor unit 120a is connected to a first electrode 121 of the second capacitor unit 120b, and a third electrode 125 of the second capacitor unit 120b is connected to a third electrode 125 of the third capacitor unit 120c.

To enable the plurality of capacitor units 120 in each row to be disposed in series, the plurality of capacitor units 120 in series may form a bit line BL, so that a level applied to the bit line BL can be changed to select the plurality of capacitor units 120 in the row, and then, a specific capacitor in a specific capacitor unit 120 can be selected in combination with a word line WL.

It may be understood that the memory array 100 may further include first connection structures 131 and second connection structures 132. A third electrode 125 of one capacitor unit 120 in one row may be connected to a third electrode 125 of an adjacent capacitor unit 120 via a first connection structure 131. In other words, the third electrodes 125 of the two adjacent capacitor units 120 may be connected to each other via the first connection structure 131. Because the third electrode 125 extends in the thickness direction D of the substrate 110 and is surrounded by the second electrode 123, to facilitate connection between the two adjacent third electrodes 125, the first connection structure 131 may be disposed on a side that is of the third electrode 125 and that is away from the substrate. In other words, the first connection structure 131 may be disposed on a side that is of the two adjacent capacitor units 120 and that is away from the substrate. A first electrode 121 of one capacitor unit 120 in one row may be connected to a first electrode 121 of an adjacent capacitor unit 120 via a second connection structure 132. In other words, the first electrodes 121 of the two adjacent capacitor units 120 may be connected to each other via the second connection structure 132. Because the first electrode 121 is disposed on a periphery of the capacitor unit 120, the two adjacent capacitor units 120 may be directly connected to each other via the second connection structure 132. For ease of disposition, the second connection structure 132 may be disposed close to the substrate 110.

Still as shown in FIG. 4, in one row of capacitor units 120, first connection structures 131 and second connection structures 132 may be alternately disposed. For example, one row of capacitor units 120 include the first capacitor unit 120a, the second capacitor unit 120b, and the third capacitor unit 120c that are sequentially arranged. The first electrode 121 of the first capacitor unit 120a may be connected to the first electrode 121 of the second capacitor unit 120b via a second connection structure 132. The second capacitor unit 120b is disposed between the third capacitor unit 120c and the first capacitor unit 120a. The third electrode 125 of the third capacitor unit 120c is connected to the third electrode 125 of the second capacitor unit 120b via a first connection structure 131. In this way, the row of capacitor units 120 can be connected. In the row of capacitor units 120, except for two capacitor units 120 at the beginning and the end of the row, a first electrode 121 of another capacitor unit 120 is connected to a first electrode 121 of an adjacent capacitor unit 120, and a third electrode 125 is connected to a third electrode 125 of another adjacent capacitor unit 120.

Based on the circuit structure, the memory array 100 further includes a plurality of transistors 140, and each transistor 140 includes a first electrode 141 and a second electrode 142. Still as shown in FIG. 4, the plurality of transistors 140 may be disposed between the substrate 110 and the plurality of capacitor units 120. For example, when the transistor 140 is a field effect transistor (MOSFET), the transistor 140 includes a first electrode 141, a second electrode 142, and a gate 143. The first electrode 141 and the second electrode 142 may be formed inside or on a surface of the substrate 110. The gate 143 may be formed between the first electrode 141 and the second electrode 142 of the corresponding transistor 140. The gate 143 may be buried in the substrate 110. After the transistor 140 is formed on the substrate 110, it may be considered that the transistor 140 is not a part of the substrate 110, and the substrate 110 includes only a part in which no transistor 140 is formed. Therefore, it may be considered that the plurality of transistors 140 may be disposed between the substrate 110 and the plurality of capacitor units 120.

It may be understood that the memory array 100 may control, via a transistor 140, a capacitor of a corresponding capacitor unit 120 to perform reading/writing. Therefore, the plurality of transistors 140 included in the memory array 100 may be disposed in correspondence with the plurality of capacitor units 120. In this case, the plurality of transistors 140 may also be arranged in an array. In addition, one row of transistors 140 may be correspondingly connected to one row of capacitor units 120. To be specific, every two transistors 140 in one row of transistors 140 are disposed in correspondence with a capacitor 1201a and a capacitor 1201b of one capacitor unit 120 in one row of corresponding capacitor units 120. For example, a plurality of transistors 140 in one row of transistors 140 include a first transistor 140a and a second transistor 140b, and the first transistor 140a and the second transistor 140b are correspondingly connected to a capacitor 1201a and a capacitor 1201b of a corresponding capacitor unit 120. The first transistor 140a and the second transistor 140b may be disposed adjacent to each other, or may not be disposed adjacent to each other.

The first transistor 140a and the second transistor 140b are disposed adjacent to each other. In some possible implementations, in each row, in two adjacent transistors 140, a first electrode 141 of one transistor 140 may be a second electrode 142 of the other transistor 140, or a second electrode 142 of one transistor 140 may be a first electrode 141 of the other transistor 140. In other words, a second electrode 142 of the first transistor 140a and a first electrode 141 of the second transistor 140b are a same electrode. For example, as shown in FIG. 4, the second electrode 142 of the transistor 140a and the first electrode 141 of the transistor 140b are the same electrode. In this case, a first electrode 141 of the first transistor 140a may be connected to a first electrode 121 of a corresponding capacitor unit 120, the second electrode 142 of the first transistor 140a (which is also the first electrode 141 of the second transistor 140b) may be connected to a second electrode 123 of a corresponding capacitor unit 120, and a second electrode 142 of the second transistor 140b may be connected to a third electrode 125.

A second electrode 123 of a capacitor unit 120 may be directly connected to a same electrode of a first transistor 140a and a second transistor 140b that are disposed adjacent to each other. For example, as described above, the second electrode 123 is at least partially cylindrical. In other words, a part of the second electrode 123 is cylindrical. The part may be referred to as a first part 1231 of the second electrode 123. In addition to the cylindrical first part 1231, the second electrode 123 further includes a second part 1232. The second part 1232 is located at an end that is of the first part 1231 and that is close to the substrate 110, and an edge of the second part 1232 is connected to the end that is of the first part 1231 and that is close to the substrate 110. The second part 1232 may seal the end that is of the cylindrical first part 1231 and that is close to the substrate 110. The second part 1232 is in direct contact with a same electrode of the first transistor 140a and the second transistor 140b, so that the second electrode 123 is connected to the first transistor 140a and the second transistor 140b at the same time.

In some other possible implementations, the first transistor 140a and the second transistor 140b do not share a same electrode. A first electrode 141 of the first transistor 140a may be connected to a first electrode 121 of a corresponding capacitor unit 120, and a second electrode 142 of the first transistor 140a may be connected to a second electrode 123 of a corresponding capacitor unit 120. A first electrode 141 of the second transistor 140b may be connected to a second electrode 123, and a second electrode 142 of the second transistor 140b may be connected to a third electrode 125.

To enable the plurality of transistors 140 to be disposed in correspondence with the plurality of capacitor units 120, a plurality of capacitor units 120 in one row may be connected in series to each other via first connection structures 131 or second connection structures 132. Therefore, the first connection structure 131 or the second connection structure 132 may be connected to at least one transistor 140, so that the transistor 140 is connected in parallel to a corresponding capacitor 1201a or capacitor 1201b. A contact region 134 is disposed on a first electrode 141 and/or a second electrode 142 of the transistor 140, and the contact region 134 implements ohmic contact when the first electrode 141 and the second electrode 142 of the transistor are connected to the first connection structure 131 or the second connection structure 132.

In some implementations, because the first connection structure 131 connects third electrodes 125 of two adjacent capacitor units 120 on a side that is of the capacitor units 120 and that is away from the substrate 110, to connect the third electrodes 125 of the two adjacent capacitor units 120 to the transistor 140, the memory array 100 may further include contact structures 133, where one end of the contact structure 133 is connected to the first connection structure 131, and the other end of the contact structure 133 is connected to at least one transistor 140. As described above, when one row of transistors 140 are disposed in series, two adjacent transistors 140 in the row of transistors 140 may share a same electrode. In this case, the other end of the contact structure 133 may be connected to the same electrode of the two adjacent transistors 140. In addition, when the row of transistors 140 are disposed in series, a first electrode 141 of one of the two adjacent transistors 140 in the row of transistors 140 may be a second electrode 142 of the other transistor 140. In this case, the other end of the contact structure 133 may be connected to the first electrode 141 of one of the two adjacent transistors 140 and the second electrode 142 of the other transistor 140 at the same time. If a transistor 140 is the last transistor 140 in the row of transistors 140, the other end of the contact structure 133 is connected to only the transistor 140.

In some possible implementations, the contact structure 133 may be made of a same material as the first connection structure 131, and the contact structure 133 and the first connection structure 131 may be formed by using a same process. For example, the contact structure 133 and the first connection structure 131 are formed at the same time by using a same sputtering or chemical vapor deposition process. In some specific implementations, the contact structure 133, the first connection structure 131, and third electrodes 125 of two adjacent capacitor units 120 connected to the first connection structure 131 are all made of a same material, and may be formed at the same time by using a same process. In addition, because there is a connection relationship between the contact structure 133, the first connection structure 131, and the third electrodes 125 of the two adjacent capacitor units 120 connected to the first connection structure 131, the contact structure 133, the first connection structure 131, and the third electrodes 125 of the two adjacent capacitor units 120 connected to the first connection structure 131 may also be disposed integrally.

In some implementations, because the second connection structure 132 is disposed close to the substrate 110. In other words, the second connection structure 132 may be disposed between two adjacent capacitor units 120, and disposed on a side that is of the transistor 140 and that is away from the substrate 110. Therefore, to connect one transistor 140 in parallel to one capacitor 1201a or capacitor 1201b, the second connection structure 132 may be in direct contact with the transistor 140. In other words, the second connection structure 132 may be directly connected to a first electrode 141 or a second electrode 142 of the transistor 140. Similarly, the second connection structure 132 and first electrodes 121 of the two adjacent capacitor units 120 connected to the second connection structure 132 may be made of a same material, and may be formed at the same time by using a same process. In this case, the second connection structure 132 and the first electrodes 121 of the two adjacent capacitor units 120 connected to the second connection structure 132 may be disposed integrally.

In this way, two capacitors 1201a and 1201b in one capacitor unit 120 are respectively connected in parallel to two transistors 140a and 140b.

Still as shown in FIG. 4, the plurality of transistors 140 in the memory array 100 are arranged in the array. Because one row of transistors 140 are disposed in series, the row of transistors 140 may also be considered as a bit line BL of the memory array 100. The row of transistors 140 are correspondingly connected to one row of capacitor units 120. In other words, two capacitors 1201a and 1201b in one capacitor unit 120 are respectively connected in parallel to two transistors 140a and 140b. The memory array 100 further includes a plurality of word lines WL, and the plurality of word lines WL may be embedded in the substrate 110. The transistor 140 may also include a gate 143. The plurality of word lines WL are connected to gates 143 of one column of transistors 140. In this way, one capacitor may be selected via one word line WL and one bit line BL, to perform a read/write operation on the capacitor.

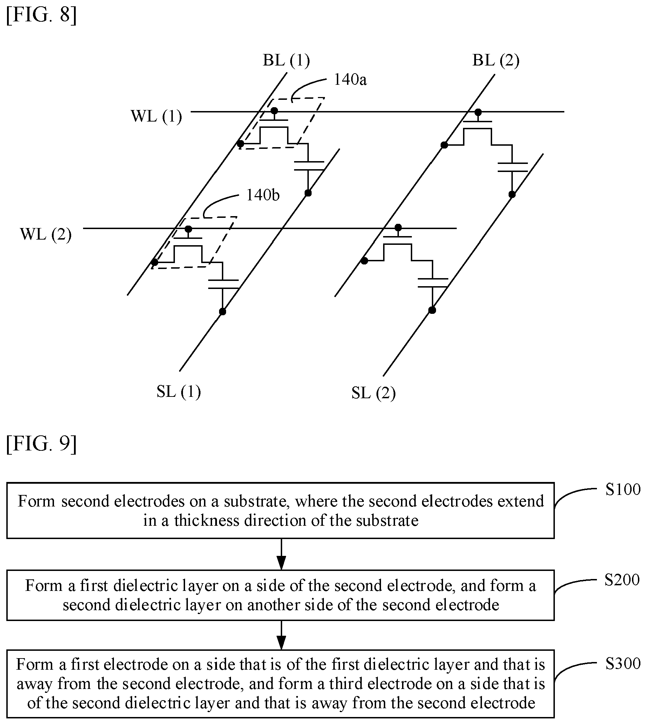

FIG. 7 is a diagram of a front cross-sectional structure of another memory array 100. FIG. 8 is a circuit schematic of the memory array 100. The memory array 100 in FIG. 7 may also include capacitor units 120. A difference between the memory array 100 in FIG. 7 and the memory array 100 in FIG. 4 lies in that, in the memory array 100 in FIG. 7, transistors 140 and capacitors of the capacitor units 120 are disposed in series, while in the memory array 100 in FIG. 4, the transistors 140 and the capacitors of the capacitor units 120 are disposed in parallel.

Still as shown in FIG. 8, the memory array 100 may include a plurality of word lines WL, a plurality of bit lines BL, and a plurality of source lines SL. A plurality of word lines WL may be disposed in a first direction, a plurality of bit lines BL may be disposed in a second direction, and the first direction and the second direction may intersect. A memory cell may be disposed between any word line WL and any bit line BL. The memory cell may include one transistor and one capacitor. The transistor may include a first electrode, a second electrode, and a gate. The gate may be connected to the word line WL, the first electrode may be connected to the bit line BL, the second electrode may be connected to one electrode of the capacitor, and the other electrode of the capacitor may be connected to a source line SL.

The capacitor may be one of two capacitors in the capacitor unit 120. To be specific, the capacitor may be one capacitor 1201b that is in the capacitor unit 120 and that is formed by at least a first electrode 121, a first dielectric layer 127, and a second electrode 123, or may be the other capacitor 1201a that is in the capacitor unit 120 and that is formed by at least a second electrode 123, a second dielectric layer 129, and a third electrode 125. As shown in FIG. 7, the capacitor unit 120 may also be disposed on the substrate 110.

In some implementations, because one capacitor unit 120 includes two capacitors, the two capacitors in the capacitor unit 120 may be correspondingly connected to two transistors 140 respectively. For example, the two transistors may be respectively a first transistor 140a and a second transistor 140b. A first electrode 121 of the capacitor unit 120 is connected to a first electrode 141 or a second electrode 142 of the first transistor 140a, a third electrode 125 of the capacitor unit 120 is connected to a first electrode 141 or a second electrode 142 of the second transistor 140b, a second electrode 123 of the capacitor unit 120 is connected to a power signal end, and the power signal end may be a source line SL. In addition, a gate of the first transistor 140a and a gate of the second transistor 140b may be respectively connected to a first word line WL (1) and a second word line WL (2), and the first electrode 141 or the second electrode 142 of the first transistor 140a may be connected to a same bit line BL as the first electrode 141 or the second electrode 142 of the second transistor 140b.

In this way, a word line WL is set to a high level, a gate 143 connected to the word line WL is set to a high level, a transistor 140 corresponding to the gate 143 is conducted, and charges stored in a capacitor connected to the transistor 140 may be obtained or changed via a bit line BL of the transistor 140, to perform a read/write operation on a memory cell formed by the transistor 140 and the capacitor.

In some implementations, to facilitate connection to the capacitor unit 120, a first part 1231 of the second electrode 123 may be cylindrical. In addition to the cylindrical first part 1231, the second electrode 123 further includes a second part 1232. The second part 1232 may be located at an end that is of the first part 1231 and that is away from the substrate 110, and an edge of the second part 1232 is connected to the end that is of the first part 1231 and that is away from the substrate 110. The second part 1232 may seal the end that is of the cylindrical first part 1231 and that is away from the substrate 110. The second part 1232 may be connected to the source line SL, so that the two capacitors in the capacitor unit 120 are connected to the source line SL at the same time.

In some implementations, the memory array 100 may include the plurality of capacitor units 120 and the plurality of transistors 140, and the plurality of capacitor units 120 may be arranged in an array on the substrate 110. Because every two transistors 140 correspond to one capacitor unit 120, the plurality of transistors 140 may also be arranged in an array on the substrate 110. To facilitate electrical connection, gates of transistors 140 in each row or each column may be connected to a same word line WL. In addition, gates 143 of the plurality of transistors 140 may be embedded in the substrate 110. Correspondingly, the word line WL connected to the gates of the transistors 140 in each row or each column may also be embedded in the substrate 110. The gates 143 of the plurality of transistors 140 may also be disposed integrally with corresponding word lines WL.

Although this application describes only an example of a memory array formed by one layer of memory cells, it is easily understood that this application is also applicable to a memory array in which a plurality of layers are stacked. Details are not described in this application.

In addition, an embodiment of this application further provides a preparation method for a memory array. FIG. 9 is a flowchart of preparing a memory array. The preparation method may include the following steps.

S100: Form second electrodes 123 on a substrate 110, where the second electrodes 123 extend in a thickness direction D of the substrate 110.

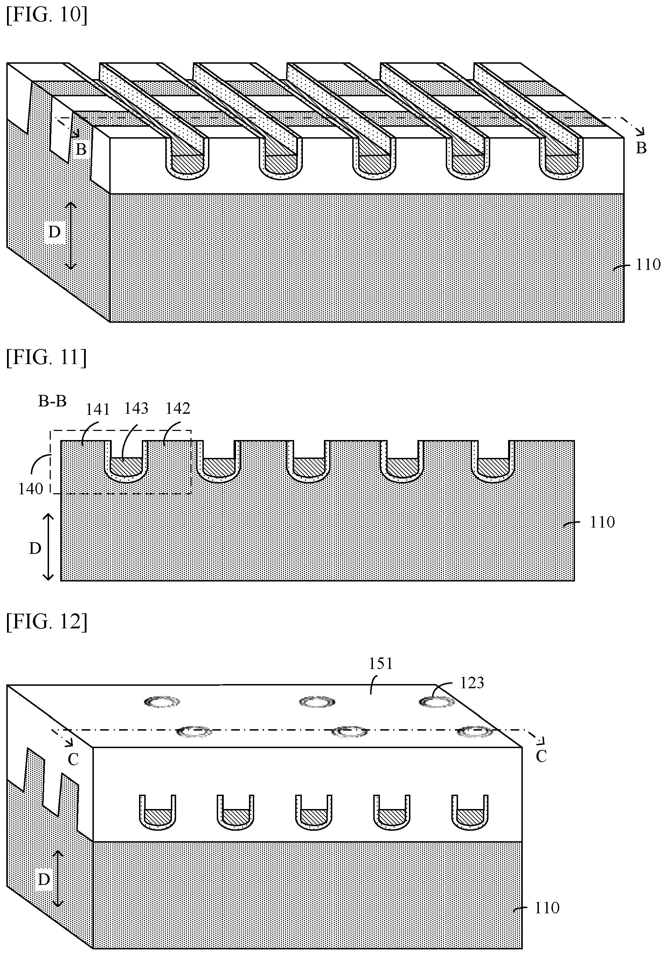

First, the substrate 110 is provided, as shown in FIG. 10 and FIG. 11. FIG. 10 is a diagram of a three-dimensional structure of the substrate 110. FIG. 11 is a diagram of a cross-sectional structure in a B-B direction in FIG. 10. Transistors 140 are formed on the substrate 110. The transistors 140 may be distributed in an array on the substrate 110. The transistor 140 may include a first electrode 141, a second electrode 142, and a gate 143. The transistor 140 may be embedded in the substrate 110. For example, the first electrode 141 and the second electrode 142 of the transistor 140 may be formed by doping the substrate 110, a groove may be formed between the first electrode 141 and the second electrode 142, and the gate 143 may be formed after a gate dielectric layer is formed in the groove. The gate 143 may be made of metal, for example, tungsten (W). The gate dielectric layer may be made of a high-K dielectric material, for example, aluminum oxide (Al₂O₃).

The transistors 140 may be arranged in the array. In other words, the transistors 140 may be arranged in a plurality of rows and a plurality of columns. A direction of each row may be in the B-B direction, and a direction of each column may be perpendicular to the B-B direction. Each row of transistors 140 may be disposed in series, and a first electrode 141 of one of adjacent transistors 140 in each row of transistors 140 is connected to a second electrode 142 of the other transistor 140. In some implementations, a first electrode 141 of one of adjacent transistors 140 and a second electrode 142 of the other transistor 140 may be a same electrode. For ease of description, the following uses an example in which a first electrode 141 of one of adjacent transistors 140 and a second electrode 142 of the other transistor 140 are a same electrode.

Gates 143 of each column of transistors 140 may be connected to a same word line WL. In some implementations, the gates 143 of each column of transistors 140 may be formed integrally. To be specific, the gates 143 of each column of transistors 140 extend in an arrangement direction of the column of transistors 140, and extend from at least a 1^{st} transistor 140 to the last transistor 140 in the column of transistors 140.

In some implementations, second electrodes 123 may be formed on first electrodes 141 or second electrodes 142 of each row of transistors 140. For example, when two adjacent transistors 140 in each row of transistors 140 share a same electrode, every two second electrodes 123 may be spaced by one electrode (a first electrode 141 or a second electrode 142).

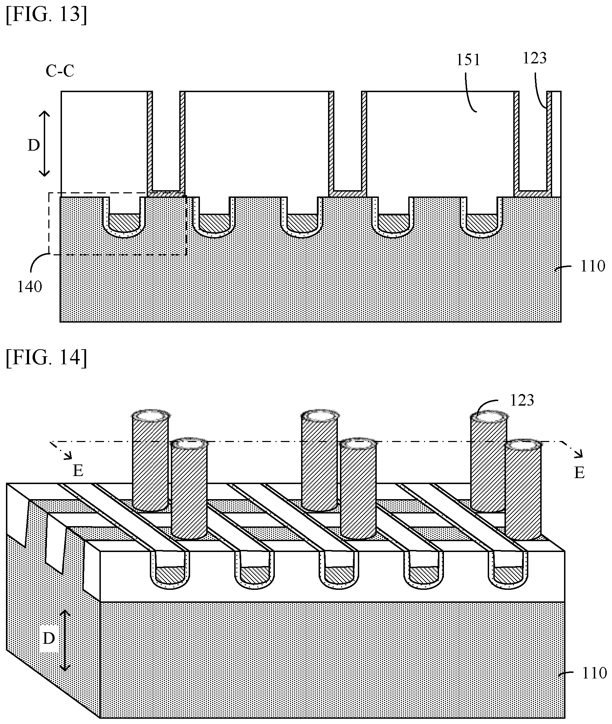

FIG. 12 is a diagram of a structure after the second electrodes 123 are formed. FIG. 13 is a diagram of a cross-sectional structure in a C-C direction in FIG. 12. Before the second electrode 123 is formed, a sacrificial layer 151 is formed on the substrate 110. The sacrificial layer 151 may be made of an insulating material. For example, a material of the sacrificial layer 151 is silicon oxide (SiO₂). The sacrificial layer 151 may be formed by using a CVD (Chemical Vapor Deposition) process. The sacrificial layer 151 fills a groove that is formed between the first electrode 141 and the second electrode 142 on the substrate 110 and that is not filled with the gate 143, and extends away from the substrate 110 in the thickness direction D of the substrate 110 by a specific size. In some implementations, the size is the same as a size by which the second electrode 123 extends in the thickness direction D of the substrate 110.

After the sacrificial layer 151 is formed, a mask layer may be formed on a surface of the sacrificial layer 151, and a pattern is formed on the mask layer by using a photolithography process. The pattern exposes the sacrificial layer 151 at a position at which the second electrode 123 is pre-formed. For example, holes arranged in an array are formed on the mask layer. A position of the hole corresponds to the position at which the second electrode 123 is pre-formed, and a shape of the hole is the same as a shape formed by an outer edge of a cross section of the second electrode 123. The sacrificial layer 151 is etched through the holes formed on the mask layer, to form deep holes on the sacrificial layer 151. A plasma etching process may be used for etching to implement anisotropic etching.

Then, the second electrode 123 is formed in the formed deep hole. The second electrode 123 may be formed by using a deposition process, for example, a PVD (Physical Vapor Deposition) process or an ALD (Atomic Layer Deposition) process. In other words, the second electrode 123 may be formed by attaching a layer of electrode material to an inner surface of the deep hole, where the inner surface of the deep hole includes a bottom surface of the deep hole. The formed second electrode 123 extends in the thickness direction of the substrate 110. A thickness of the attached electrode material is a thickness of the second electrode 123. The thickness of the second electrode 123 may range from 5 nm to 15 nm, for example, may be 5 nm, 8 nm, or 15 nm. It is easily understood that a shape of the inner surface of the deep hole is a shape of a surface of one side of the second electrode 123. A material of the second electrode 123 may be a conductive material, for example, titanium nitride (TiN).

S200: Form a first dielectric layer 127 on a side of the second electrode 123, and form a second dielectric layer 129 on another side of the second electrode 123.

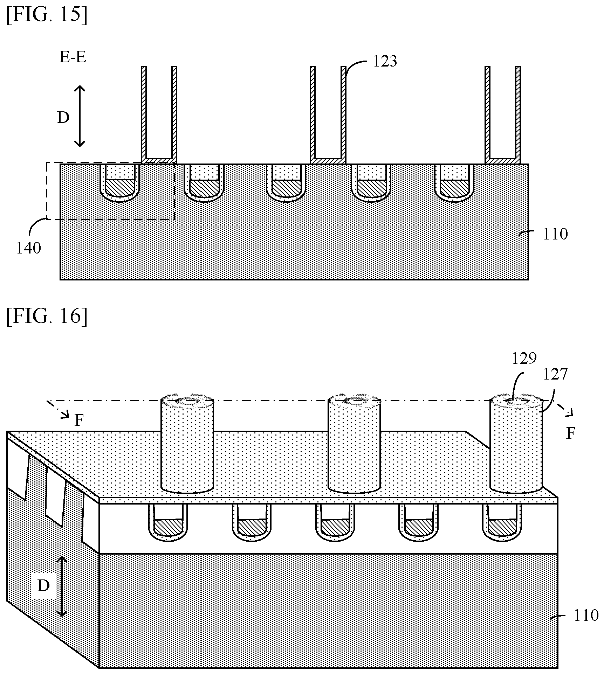

After the second electrode 123 is formed, the sacrificial layer 151 is removed. FIG. 14 is a diagram of a structure after the sacrificial layer 151 is removed. FIG. 15 is a diagram of a cross-sectional structure in an E-E direction in FIG. 14. The sacrificial layer 151 may be removed by using a wet etching process. After the sacrificial layer 151 is removed, neither of two sides of the second electrode 123 is blocked. In this case, only the second electrode 123 is disposed on a surface of the substrate 110.

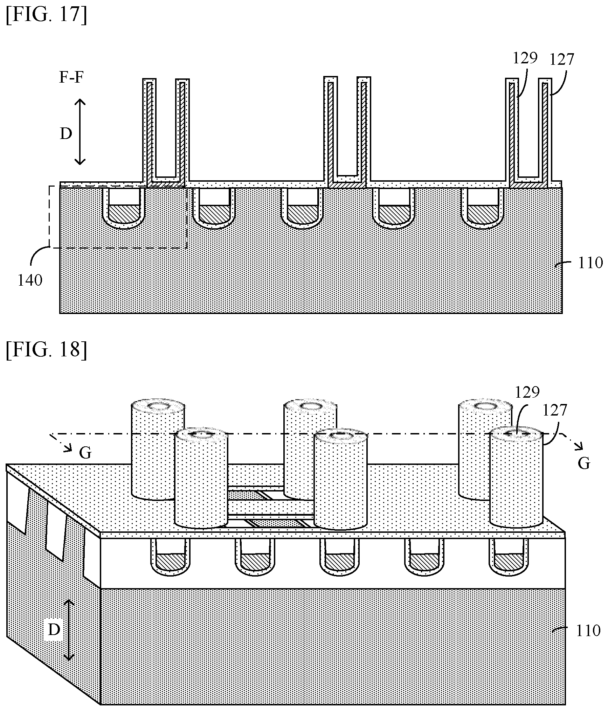

Then, the first dielectric layer 127 may be formed on the side of the second electrode 123, and the second dielectric layer 129 may be formed on the another side of the second electrode 123. FIG. 16 is a diagram of a structure after the first dielectric layer 127 and the second dielectric layer 129 are formed. FIG. 17 is a diagram of a cross-sectional structure in an F-F direction in FIG. 16. The first dielectric layer 127 and the second dielectric layer 129 may be formed by using the deposition process, for example, the ALD (Atomic Layer Deposition) process. In some implementations, a part that is of the second electrode 123 and that extends in the thickness direction of the substrate 110 is cylindrical. Therefore, the first dielectric layer 127 may be formed on an outer surface of the second electrode 123, and the second dielectric layer 129 may be formed on an inner surface of the second electrode 123.

It is easily understood that the first dielectric layer 127 and the second dielectric layer 129 may be formed at the same time through deposition by using a same process. In addition, because the dielectric layer formed by using the deposition process is also formed on an upper edge of the second electrode 123, the first dielectric layer 127 is connected to the second dielectric layer 129 on a side that is of the second electrode 123 and that is away from the substrate 110, to form an integrated structure.

S300: Form a first electrode 121 on a side that is of the first dielectric layer 127 and that is away from the second electrode 123, and form a third electrode 125 on a side that is of the second dielectric layer 129 and that is away from the second electrode 123, where the first electrode 121 and the second electrode 123 extend in the thickness direction of the substrate 110, the second electrode 123 surrounds the first electrode 121, and the third electrode 125 surrounds the second electrode 123.

After the first dielectric layer 127 is formed on the side of the second electrode 123 and the second dielectric layer 129 is formed on the another side of the second electrode 123, the first electrode 121 and the third electrode 125 may further be formed. The first electrode 121 and the third electrode 125 may be made of the same material as the second electrode 123, and a process for forming the first electrode 121 and the third electrode 125 may also be the same as the process for forming the second electrode 123. It is easily understood that the first electrode 121 and the third electrode 125 may be formed at the same time by using the same process.

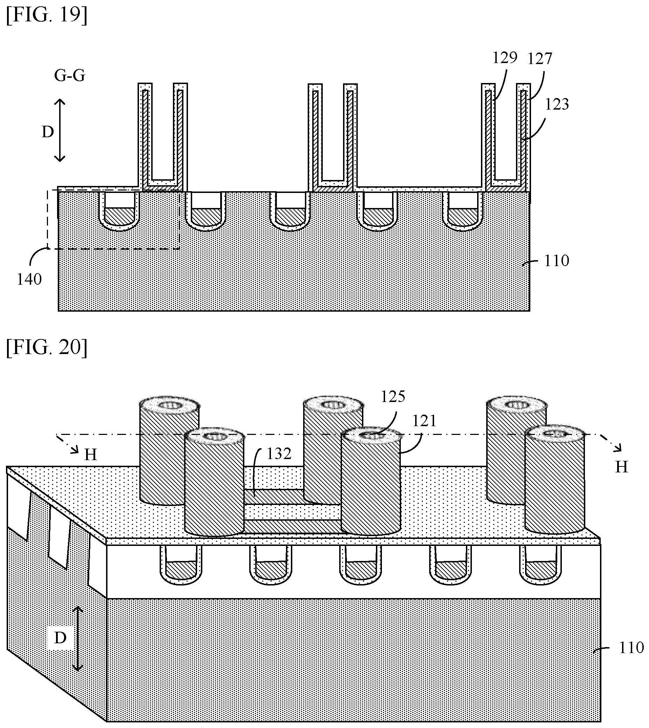

In some implementations, because the capacitor unit 120 is connected to the transistor 140 embedded in the substrate 110, the first electrode 121 may be connected to the transistor 140 while the first electrode 121 is formed. Before the first electrode 121 is formed, a part of dielectric layer that covers the surface of the substrate 110 due to formation of the first dielectric layer 127 and the second dielectric layer 129 may be removed by using the photolithography process and the etching process, to expose a part of surface of the substrate 110. FIG. 18 is a diagram of a structure after the part of dielectric layer is removed. FIG. 19 is a diagram of a cross-sectional structure in a G-G direction in FIG. 18.

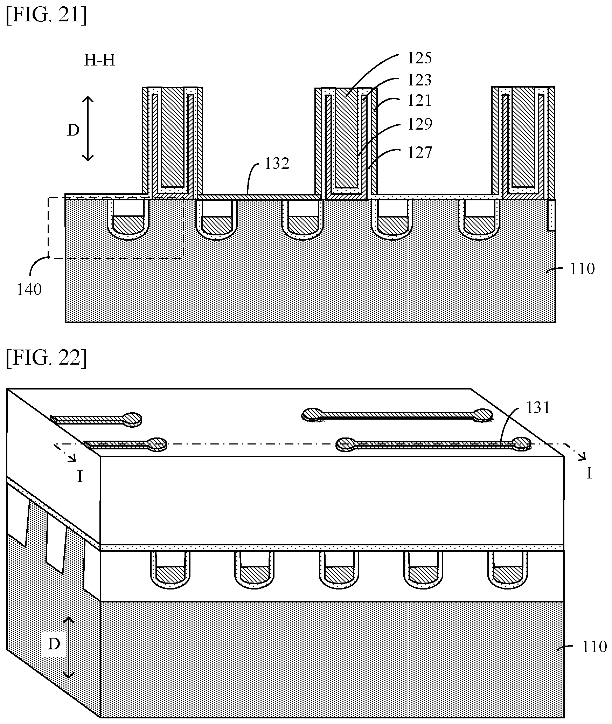

Therefore, as shown in FIG. 20 and FIG. 21, when the first electrode 121 and the third electrode 125 are formed by using the deposition process, a conductive material (which is the same as the material of the first electrode 121 and the second electrode 123) may be formed on the exposed part of surface of the substrate. The conductive material may form a second connection structure 132. The second connection structure 132 connects first electrodes 121 of two adjacent capacitor units 120 in each row of capacitor units 120, and also connects the first electrodes 121 to first electrodes 141 or the second electrodes 142 of transistors 140. The second connection structure 132 connects only some two adjacent capacitor units 120 in one row of capacitor units 120. For example, one row of capacitor units 120 are sequentially arranged, and some adjacent two capacitor units 120 may be these two adjacent capacitor units including only a capacitor unit at each odd position and a capacitor unit arranged after the capacitor unit in the row of capacitor units 120, or may be these two adjacent capacitor units including only a capacitor unit at an even position and a capacitor unit arranged after the capacitor unit in the row of capacitor units 120.

The removed part of dielectric layer may correspond to at least a part between the some two adjacent capacitor units 120. The removed part of dielectric layer may connect first electrodes 121 of the adjacent capacitor units 120 to transistors 140. To be specific, in one row of capacitor units 120, a dielectric layer between a 1^{st} capacitor unit and a 2^{nd} capacitor unit may be removed, a dielectric layer between the 2^{nd} capacitor unit and a 3^{rd} capacitor unit may be retained, and a dielectric layer between the 3^{rd} capacitor unit and a 4^{th} capacitor unit may be removed. The process is repeated.

It is easily understood that, as shown in FIG. 20 and FIG. 21, when the first electrode 121, the second electrode 123, and the second connection structure 132 are formed at the same time, the conductive material also covers the upper surface of the substrate 110. Therefore, after the first electrode 121, the second electrode 123, and the second connection structure 132 are formed, a part of conductive material also needs to be removed, and the part of conductive material does not correspond to the removed dielectric layer. In other words, after the part of conductive material is removed, the remaining conductive material covers a position exposed after the dielectric layer is removed. FIG. 20 is a diagram of a structure after a redundant conductive material is removed. FIG. 21 is a diagram of a cross-sectional structure in an H-H direction in FIG. 20. For example, an unnecessary conductive material may be removed by using the photolithography process and the etching process.

Finally, the third electrode 125 needs to be connected to the transistor 140. After the first electrode 121 and the third electrode 125 are formed, an insulating material, for example, SiO₂, may be deposited on the substrate 110. The insulating material may completely cover the first electrode 121 and the third electrode 125. In other words, the first electrode 121 and the third electrode 125 are not exposed to an upper surface formed by the insulating material.

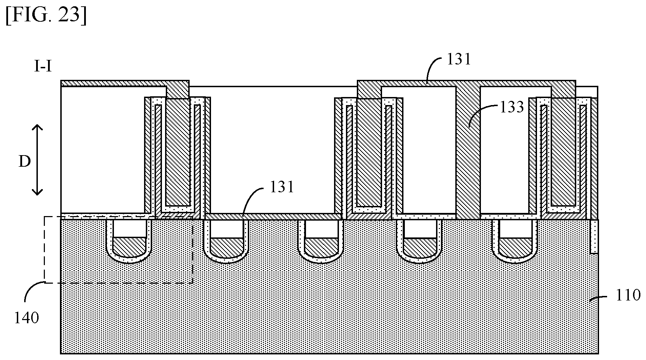

As shown in FIG. 22 and FIG. 23, to connect the third electrode 125 to the transistor 140, a contact hole may be formed on the upper surface of the insulating material by using the photolithography process and the etching process, and a first connection structure 131 and a contact structure 133 are formed by depositing a conductive material in the contact hole. Because the deposited conductive material covers the entire upper surface of the insulating material, a conductive material other than the first connection structure 131 and the contact structure 133 needs to be removed, to form only the first connection structure 131 and the contact structure 133. FIG. 22 is a diagram of a structure after a redundant conductive material is removed. FIG. 23 is a diagram of a cross-sectional structure in an I-I direction in FIG. 22. Third electrodes 125 of two adjacent capacitor units 120 are connected to each other via the first connection structure 131, and the first connection structure 131 is connected to transistors 140 via the contact structure 133. In other words, the third electrodes 125 of the two adjacent capacitor units 120 are connected to the transistors 140.

Specific process steps of the preparation method are described by using a structure corresponding to the circuit architecture in FIG. 6 as an example. For a structure corresponding to another circuit architecture (for example, a structure shown in FIG. 8), without departing from the inventive concept of this application, reference may be made to the foregoing method steps, and the process steps may be adaptively adjusted based on different structures.

The descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory array, comprising:
a substrate; and
capacitor units disposed on the substrate, wherein the capacitor unit comprises a first electrode, a second electrode, and a third electrode. The first electrode, the second electrode, and the third electrode all extend in a thickness direction of the substrate, the first electrode is disposed around the second electrode, and the second electrode is disposed around the third electrode. The capacitor unit further comprises a first dielectric layer and a second dielectric layer, the first dielectric layer is disposed between the first electrode and the second electrode, and the second dielectric layer is disposed between the second electrode and the third electrode.

2. The memory array according to claim 1, wherein at least a part of the second electrode is cylindrical, and at least a part of the first electrode is cylindrical.

3. The memory array according to claim 1 or 2, wherein the first dielectric layer is connected to the second dielectric layer on a side that is away from the substrate.

4. The memory array according to any one of claims 1 to 3, wherein the memory array comprises the plurality of capacitor units arranged in an array, and third electrodes or first electrodes of any two adjacent capacitor units in one row of capacitor units are connected to each other.

5. The memory array according to claim 4, further comprising a first connection structure, disposed on a side that is of the two adjacent capacitor units and that is away from the substrate, wherein the third electrodes of the two adjacent capacitor units are connected to each other via the first connection structure.

6. The memory array according to claim 5, further comprising:
a plurality of transistors, disposed between the substrate and the plurality of capacitor units; and
contact structures, wherein one end of the contact structure is connected to the first connection structure, and the other end of the contact structure is connected to at least one transistor.

7. The memory array according to claim 6, wherein the third electrodes of the two adjacent capacitor units, the first connection structure, and the contact structure are made of a same material and are disposed integrally.

8. The memory array according to claim 4, further comprising a second connection structure, disposed between the two adjacent capacitor units and disposed close to the substrate, wherein the first electrodes of the two adjacent capacitor units are connected to each other via the second connection structure.

9. The memory array according to claim 8, further comprising a plurality of transistors, disposed between the substrate and the plurality of capacitor units, wherein the second connection structure is in contact with at least one transistor.

10. The memory array according to claim 8, wherein the first electrodes of the two adjacent capacitor units and the second connection structure are made of a same material and are disposed integrally.

11. The memory array according to any one of claims 4 to 10, further comprising first connection structures and second connection structures, wherein in one row of capacitor units, the first connection structures and the second connection structures are alternately disposed.

12. The memory array according to any one of claims 1 to 10, wherein the plurality of transistors in the memory array comprise a first transistor and a second transistor, a first electrode of the first transistor is connected to the first electrode, both a second electrode of the first transistor and a first electrode of the second transistor are connected to the second electrode, and a second electrode of the second transistor is connected to the third electrode.

13. The memory array according to claim 12, wherein the second electrode of the first transistor and the first electrode of the second transistor are a same electrode; and
the second electrode comprises a cylindrical first part and a second part located at an end that is of the first part and that is close to the substrate, an edge of the second part is connected to the end that is of the first part and that is close to the substrate, and the second part is in contact with the same electrode.

14. The memory array according to any one of claims 1 to 13, wherein the plurality of transistors in the memory array are arranged in an array, and one row of transistors are disposed in series, and are correspondingly connected to one row of capacitor units; and
the memory array further comprises a plurality of word lines embedded in the substrate, and one word line is connected to gates of one column of transistors.

15. The memory array according to claim 1 or 2, further comprising a first bit line and a second bit line; and
a plurality of transistors in the memory array comprise a first transistor and a second transistor, a first electrode of the first transistor is connected to the first bit line, a second electrode of the first transistor is connected to the first electrode, a first electrode of the second transistor is connected to the third electrode, a second electrode of the second transistor is connected to the second bit line, and the second electrode is connected to a power signal end.

16. The memory array according to any one of claims 1 to 15, wherein both the first dielectric layer and the second dielectric layer are made of a ferroelectric material.

17. A preparation method for a memory array, comprising:
forming second electrodes on the substrate, wherein the second electrodes extend in a thickness direction of the substrate;
forming a first dielectric layer on a side of the second electrode, and forming a second dielectric layer on another side of the second electrode; and
forming a first electrode on a side that is of the first dielectric layer and that is away from the second electrode, and forming a third electrode on a side that is of the second dielectric layer and that is away from the second electrode, wherein the first electrode and the second electrode extend in the thickness direction of the substrate, the second electrode surrounds the first electrode, and the third electrode surrounds the second electrode.

18. The preparation method for a memory array according to claim 17, wherein the first dielectric layer and the second dielectric layer are formed at the same time.

19. A memory, comprising a peripheral circuit and the memory array according to any one of claims 1 to 16, wherein the peripheral circuit is electrically connected to the memory array.

20. An electronic device, comprising a printed circuit board and the memory according to claim 19, wherein the memory is disposed on the printed circuit board.
